# EUROPEAN PATENT APPLICATION

(11) **EP 4 485 514 A1**
(43) Date of publication of application: **01.01.2025**
(21) Application number: 23206337.0
(22) Date of filing: 27.10.2023
(51) Int. Cl.: H01L 21/74, H01L 21/768, H01L 23/535, H01L 23/532

(54) **LOW-RESISTANCE VIA STRUCTURES**

(30) Priority: 30.06.2023 US 202318217208
(71) Applicant: INTEL Corporation, Santa Clara, CA 95054 (US)
(72) Inventor: Shen, Ming-Yi, Portland, 97229 (US); Choi, Chi-Hing, Portland, 97229 (US); Mehta, Jaladhi, Beaverton, 97997 (US); Rahman, Tofizur, Portland, 97229 (US); Amin, Payam, Portland, 97229 (US); Mueller, Justin, Portland, 97229 (US); Hipwell, Vincent, Hillsboro, 97123 (US); Vogelsberg, Cortnie, Beaverton, 97008 (US); Patel, Shivani, Hillsboro, 97123 (US)
(74) Representative: Goddar, Heinz J.

(57) **Abstract**

Techniques to form low-resistance vias are discussed. In an example, semiconductor devices of a given row each include a semiconductor region extending in a first direction between corresponding source or drain regions, and a gate structure extending in a second direction over the semiconductor regions. Any semiconductor device may be separated from an adjacent semiconductor device along the second direction by a dielectric structure, through which a via passes. The via may include a conductive portion that extends through a dielectric wall in a third direction along at least an entire thickness of the gate structure. The conductive portion includes a conductive liner directly on the dielectric wall and a conductive fill on the conductive liner. The conductive liner comprises a pure elemental metal, such as tungsten, molybdenum, ruthenium, or a nickel aluminum alloy, with no metal nitride or barrier layer present between the conductive liner and the dielectric wall.

## Description

### FIELD OF THE DISCLOSURE

The present disclosure relates to integrated circuits, and more particularly, to via structures.

### BACKGROUND

As integrated circuits continue to scale downward in size, a number of challenges arise. For instance, reducing the size of memory and logic cells is becoming increasingly more difficult, particularly given competing interests in a relatively small amount of space. For instance, routing signal and power throughout the circuit can be challenging given the limited space and density of the devices. The resistance of interconnect structures to route signal and power factors into the overall speed and viability of the devices. Accordingly, there remain a number of non-trivial challenges with respect to the formation of semiconductor devices in memory or logic cells.

### BRIEF DESCRIPTION OF THE DRAWINGS

Figure 1A is a cross-section view of an integrated circuit structure that includes low-resistance via structures, in accordance with an embodiment of the present disclosure.
Figure 1B is a plan view of the integrated circuit of Figure 1A showing the low-resistance via structures extending between devices, in accordance with an embodiment of the present disclosure.
Figures 2A - 2I are cross-sectional views that illustrate stages in an example process for forming an integrated circuit configured with low-resistance via structures, in accordance with some embodiments of the present disclosure.
Figures 3A and 3B are cross-sectional views that illustrate further stages in the example process for forming the integrated circuit configured with low-resistance via structures that include removal of the substrate, in accordance with some embodiments of the present disclosure.
Figure 4 shows energy-dispersive x-ray spectroscopy (EDX) analysis across a low-resistance via structure.
Figure 5 illustrates a cross-section view of a chip package containing one or more semiconductor dies, in accordance with some embodiments of the present disclosure.
Figure 6 is a flowchart of a fabrication process for a semiconductor device having low-resistance via structures, in accordance with an embodiment of the present disclosure.
Figure 7 illustrates a computing system including one or more integrated circuits, as variously described herein, in accordance with an embodiment of the present disclosure.

Although the following Detailed Description will proceed with reference being made to illustrative embodiments, many alternatives, modifications, and variations thereof will be apparent in light of this disclosure. As will be further appreciated, the figures are not necessarily drawn to scale or intended to limit the present disclosure to the specific configurations shown. For instance, while some figures generally indicate perfectly straight lines, right angles, and smooth surfaces, an actual implementation of an integrated circuit structure may have less than perfect straight lines, right angles (e.g., some features may have tapered sidewalls and/or rounded corners), and some features may have surface topology or otherwise be non-smooth, given real world limitations of the processing equipment and techniques used.

### DETAILED DESCRIPTION

Techniques are provided herein to form low-resistance via structures. The techniques can be used in any number of via applications and are particularly useful with respect to forming via structures having a relatively high height-to-width aspect ratio, such as deep via structures that vertically extend through a device layer of an integrated circuit. The via structure may, for example, pass through a layer of dielectric material fill material, or through a dielectric structure that separates neighboring devices of a given die (e.g., such as a gate cut structure or a dielectric wall). The via may be used, for instance, to couple one or more frontside interconnect features (e.g., transistor contacts) to one or more backside interconnect features (e.g., power delivery network), although any number of interconnect schemes can be used. In any such cases, the dielectric material may be low-k dielectric material, although other dielectric materials may be used as well. In an example, the via structure includes a conductive liner directly on the dielectric wall and a conductive fill on the conductive liner. The conductive liner may be an elemental metal, such as tungsten, molybdenum, ruthenium, or a nickel aluminum alloy with no metal nitride or barrier layer present between the conductive liner and the dielectric wall. In some such examples, the conductive liner is a first metal (e.g., molybdenum) deposited by a first deposition process (e.g., physical vapor deposition, PVD) and the conductive fill is a second metal (e.g., tungsten) deposited by a second deposition process (e.g., chemical vapor deposition or atomic layer deposition, CVD or PVD). In other such examples, the first and second metals are the same elemental metal. In any such examples, the conductive liner may have a greater thickness at the bottom of the via structure, relative to its thickness on the sidewalls of the via structure. Numerous variations and embodiments will be apparent in light of this disclosure.

### General Overview

As previously noted above, there remain a number of non-trivial challenges with respect to formation of various semiconductor structures. Power and signal routing can be challenging given the number and density of semiconductor devices on a single die. For example, power and signal routing may be performed by running conductive traces such as conductive lines and vias through dielectric material. Some vias can be used, for example, to connect any frontside interconnects with the power traces on the backside of the die (e.g., deep vias). The fabrication of such deep vias is non-trivial and the resistance of such structures can be difficult to keep low as barrier layers are often used (e.g., to promote better adhesion and/or inhibit electromigration) between the metal material and the dielectric in which the via is formed. The barrier layers often include a metal nitride material (e.g., titanium nitride, tantalum nitride, tungsten carbonitride), which can be relatively high in resistance or are less conductive compared to the metal fill portion of the via.

Thus, and in accordance with an embodiment of the present disclosure, techniques are provided herein to form low-resistance vias along semiconductor devices. The techniques allow for the formation of vias with an overall higher conductivity due to the lack of any nitride-based barrier layer. In an example, each semiconductor device includes a semiconductor or channel region, such as a fin of semiconductor material or nanoribbons, nanowires, or nanosheets of semiconductor material, that extends between source or drain regions in a first direction. A gate structure, that includes both a gate dielectric and a gate electrode, extends over the semiconductor region in a second direction different from the first direction (e.g., perpendicular to the first direction). The gate structure may extend over multiple semiconductor regions of different semiconductor devices along the second direction. According to some embodiments, the gate structure is interrupted by any number of gate cuts that extend through an entire thickness of the gate structure and may also extend in the first direction through any number of gate trenches and source/drain trenches. In some such cases, a deep via is formed within the dielectric material of a gate cut. In other cases, a deep via is formed within dielectric fill material between devices. In any such cases, the dielectric material can be a low-k dielectric material, to help reduce parasitic capacitance. The via include a metal liner and a metal fill on the metal liner. In an example, the metal liner is deposited using an ionized physical vapor deposition (PVD) technique to provide enhanced adhesion to the dielectric surfaces of the dielectric walls. The metal liner can be a pure elemental metal such as tungsten, molybdenum, ruthenium, a nickel aluminum alloy, or any other suitable metal or metal alloy with a high atomic weight (e.g., greater than 90). The metal fill may be deposited on the metal liner using, for example, chemical vapor deposition (CVD) or atomic layer deposition (ALD). The metal fill may be the same pure elemental metal as the metal liner but may also be a different elemental metal. According to some embodiments, the use of PVD for depositing the liner means that no traces of carbon, fluorine, or chlorine are present within the liner. Furthermore, the deposition of the metal liner and metal fill may be performed in-situ such that no traces of oxygen are present at the boundary between the metal liner and the metal fill. Furthermore, resistive materials such as metal nitrides are avoided.

According to an embodiment, an integrated circuit includes a semiconductor device having a semiconductor region extending in a first direction from a first source or drain region, and a gate electrode extending in a second direction over the semiconductor region, and a conductive via extending in a third direction through an entire thickness of the gate electrode and adjacent to the semiconductor device in the second direction. In some examples, the conductive via passes through a layer of dielectric material, such as dielectric fill material or a dielectric wall (separate from any gate cut). In any such cases, the conductive via comprises a conductive liner and a conductive fill on the conductive liner. The conductive liner may be a pure elemental metal or otherwise nitride-free.

According to another embodiment, an integrated circuit includes a first semiconductor device having a first semiconductor region extending in a first direction from a first source or drain region to a second source or drain region, and a first gate structure extending in a second direction over the first semiconductor region, and a second semiconductor device having a second semiconductor region extending in the first direction from a third source or drain region to a fourth source or drain region, and a second gate structure extending in the second direction over the second semiconductor region. The third source or drain region is aligned with the first source or drain region along the second direction, and the fourth source or drain region is aligned with the second source or drain region along the second direction. The integrated circuit further includes a dielectric wall extending in the first direction between and contacting the first gate structure and the second gate structure. The dielectric wall also extends in a third direction through an entire thickness of each of the first gate structure and the second gate structure. The integrated circuit further includes a conductive via extending in a third direction through an entire thickness of the dielectric wall. The conductive via comprises a conductive liner and a conductive fill on the conductive liner. The conductive liner may be a pure elemental metal directly on the dielectric wall.

According to another embodiment, a method of forming an integrated circuit includes forming a fin comprising semiconductor material, the fin extending above a substrate and extending in a first direction; forming a dielectric layer adjacent to a subfin portion of the fin; forming source or drain regions at opposite ends of the fin; forming a gate structure on the dielectric layer and over the semiconductor material and extending in a second direction; forming a dielectric wall through an entire thickness of the gate structure, the dielectric wall extending in the first direction adjacent to the fin; forming a trench through the dielectric wall, such that the trench extends along at least an entire thickness of the gate structure; forming a conductive liner of a pure elemental metal within the trench; and forming a conductive fill within a remaining portion of the trench on the conductive liner.

The techniques can be used with any type of non-planar transistors, including finFETs (sometimes called double-gate transistors, or tri-gate transistors), or nanowire and nanoribbon transistors (sometimes called gate-all-around transistors), to name a few examples. The source and drain regions can be, for example, doped portions of a given fin or substrate, or epitaxial regions that are deposited during an etch-and-replace source/drain forming process. The dopant-type in the source and drain regions will depend on the polarity of the corresponding transistor. The gate structure can be implemented with a gate-first process or a gate-last process (sometimes called a replacement metal gate, or RMG, process), or any other gate formation process. Any number of semiconductor materials can be used in forming the transistors, such as group IV materials (e.g., silicon, germanium, silicon germanium) or group III-V materials (e.g., gallium arsenide, indium gallium arsenide).

Use of the techniques and structures provided herein may be detectable using tools such as electron microscopy including scanning/transmission electron microscopy (SEM/TEM), scanning transmission electron microscopy (STEM), nano-beam electron diffraction (NBD or NBED), and reflection electron microscopy (REM); composition mapping; x-ray crystallography or diffraction (XRD); energy-dispersive x-ray spectroscopy (EDX); energy dispersive spectroscopy (EDS), secondary ion mass spectrometry (SIMS); time-of-flight SIMS (ToF-SIMS); atom probe imaging or tomography; local electrode atom probe (LEAP) techniques; 3D tomography; or high resolution physical or chemical analysis, to name a few suitable example analytical tools. For instance, in some example embodiments, such tools may indicate the presence of via structures having a highly conductive liner (e.g., without a metal-nitride adhesion or barrier layer) and fill material thereon. Any form of EDX or EDS analysis can be used to show that the via includes a pure elemental metal directly on the adjacent dielectric walls. Furthermore, such analysis may also indicate a structure including a metal liner and a metal fill, and the lack of carbon, fluorine, or chlorine atoms within the metal liner. In some cases, the liner may have a greater thickness at the bottom of the via, relative to its thickness on the sidewalls of the via, due to a PVD process. A lack of oxygen at the interface between the liner and the fill material may be further indicative of an in-situ liner-fill process. Numerous configurations and variations will be apparent in light of this disclosure.

It should be readily understood that the meaning of "above" and "over" in the present disclosure should be interpreted in the broadest manner such that "above" and "over" not only mean "directly on" something but also include the meaning of over something with an intermediate feature or a layer therebetween. Further, spatially relative terms, such as "beneath," "below," "lower," "above," "upper," "top," "bottom," and the like, may be used herein for ease of description to describe one element or feature's relationship to another element (s) or feature (s) as illustrated in the figures. The spatially relative terms are intended to encompass different orientations of the device in use or operation in addition to the orientation depicted in the figures. The apparatus may be otherwise oriented (rotated 90 degrees or at other orientations) and the spatially relative descriptors used herein may likewise be interpreted accordingly.

As used herein, the term "layer" refers to a material portion including a region with a thickness. A monolayer is a layer that consists of a single layer of atoms of a given material. A layer can extend over the entirety of an underlying or overlying structure, or may have an extent less than the extent of an underlying or overlying structure. Further, a layer can be a region of a homogeneous or inhomogeneous continuous structure, with the layer having a thickness less than the thickness of the continuous structure. For example, a layer can be located between any pair of horizontal planes between, or at, a top surface and a bottom surface of the continuous structure. A layer can extend horizontally, vertically, and/or along a tapered surface. A layer can be conformal to a given surface (whether flat or curvilinear) with a relatively uniform thickness across the entire layer.

Materials that are "compositionally different" or "compositionally distinct" as used herein refers to two materials that have different chemical compositions. This compositional difference may be, for instance, by virtue of an element that is in one material but not the other (e.g., SiGe is compositionally different than silicon), or by way of one material having all the same elements as a second material but at least one of those elements is intentionally provided at a different concentration in one material relative to the other material (e.g., SiGe having 70 atomic percent germanium is compositionally different than from SiGe having 25 atomic percent germanium). In addition to such chemical composition diversity, the materials may also have distinct dopants (e.g., gallium and magnesium) or the same dopants but at differing concentrations. In still other embodiments, compositionally distinct materials may further refer to two materials that have different crystallographic orientations. For instance, (110) silicon is compositionally distinct or different from (100) silicon. Creating a stack of different orientations could be accomplished, for instance, with blanket wafer layer transfer. If two materials are elementally different, then one of the materials has an element that is not in the other material.

### Architecture

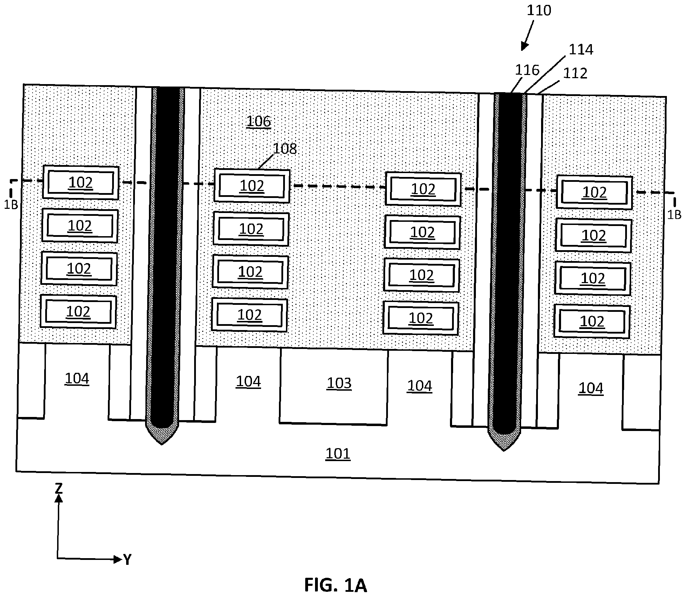

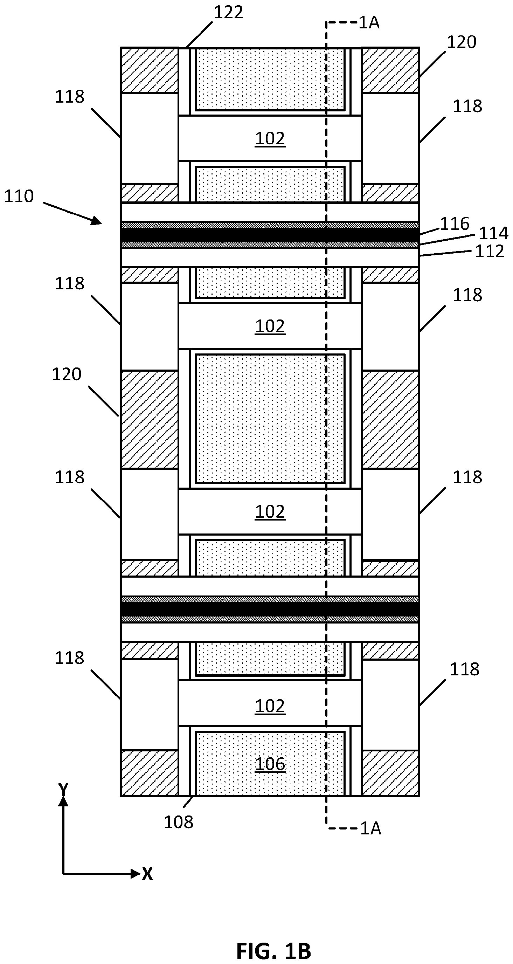

Figure 1 is a cross-section view of a portion of an integrated circuit that includes semiconductor devices and deep vias, in accordance with an embodiment of the present disclosure. Each of the semiconductor devices may be non-planar metal oxide semiconductor (MOS) transistors, such as tri-gate or gate-all-around (GAA) transistors, although other transistor topologies and types could also benefit from the techniques provided herein. The examples herein illustrate semiconductor devices with a GAA structure (e.g., having nanoribbons, nanowires, or nanosheets that extend between source and drain regions).

The one or more semiconductor regions of the devices may include fins that can be, for example, native to the substrate (formed from the substrate itself), such as silicon fins etched from a bulk silicon substrate. Alternatively, the fins can be formed of material deposited onto an underlying substrate. In one such example case, a blanket layer of silicon germanium (SiGe) can be deposited onto a silicon substrate, and then patterned and etched to form a plurality of SiGe fins extending from that substrate. In still other embodiments, the fins include alternating layers of material (e.g., alternating layers of silicon and SiGe) that facilitates forming of nanowires and nanoribbons during a gate forming process where one type of the alternating layers are selectively etched away so as to liberate the other type of alternating layers within the channel region, so that a gate-all-around process can then be carried out. Again, the alternating layers can be blanket deposited and then etched into fins or deposited into fin-shaped trenches.

The semiconductor material used in each of the semiconductor devices may be formed from a semiconductor substrate 101. Substrate 101 can be, for example, a bulk substrate including group IV semiconductor material (such as silicon, germanium, or silicon germanium), group III-V semiconductor material (such as gallium arsenide, indium gallium arsenide, or indium phosphide), and/or any other suitable material upon which transistors can be formed. Alternatively, the substrate can be a semiconductor-on-insulator substrate having a desired semiconductor layer over a buried insulator layer (e.g., silicon over silicon dioxide). Alternatively, the substrate can be a multilayer substrate or superlattice suitable for forming nanowires or nanoribbons (e.g., alternating layers of silicon and SiGe, or alternating layers indium gallium arsenide and indium phosphide). Any number of substrates can be used. In some embodiments, substrate 101 is removed and replaced with one or more backside interconnect layers to form backside signal and power routing.

Each semiconductor device includes one or more semiconductor regions, such as one or more nanoribbons 102 extending between epitaxial source or drain regions (not shown in this view) in a first direction along the X-axis. This example includes four nanoribbons 102 per device, but other examples may have two or three or other number of nanoribbons. As can further be seen, a dielectric layer 103 extends across a bottom portion of the integrated circuit and adjacent to subfins 104 of each of the semiconductor devices, according to an embodiment. Dielectric layer 103 may include any suitable dielectric material such as silicon dioxide. Dielectric layer 103 may provide shallow trench isolation (STI) between adjacent semiconductor devices. According to some embodiments, subfin 104 is a portion of the corresponding semiconductor fin that remains after formation of the various transistors and may be formed from semiconductor substrate 101. Accordingly, subfin 104 may include the same semiconductor material as the one or more semiconductor regions of the semiconductor devices.

A gate structure that includes gate electrode 106 and a gate dielectric 108 extends over the one or more semiconductor regions in a second direction (e.g., along the Y-axis) to form the transistor gate. Gate dielectric 108 may represent any number of dielectric layers. Gate electrode 106 may include any sufficiently conductive material such as a metal, metal alloy, or doped polysilicon. In some embodiments, gate electrode 106 includes one or more workfunction metals around the one or more semiconductor regions. In some embodiments, p-channel devices include a workfunction metal having titanium around its one or more semiconductor regions and n-channel devices include a workfunction metal having tungsten around its one or more semiconductor regions. Gate electrode 106 may also include a fill metal or other conductive material around the workfunction metals to provide the whole gate electrode structure. A given gate structure may extend over the semiconductor regions of more than one semiconductor device.

According to some embodiments, one or more vias 110 may extend across the gate structure in the first direction (e.g., parallel to the length of nanoribbons 102), and may continue to extend in the first direction across any number of other gate trenches and source/drain trenches. Via 110 may include a dielectric wall 112 and a conductive portion through or within dielectric wall 112 that extends along a third direction (e.g., along the Z-axis) to route logic signals, power, or ground between topside and bottom side interconnects.

Dielectric wall 112 may include any suitable dielectric material, such as silicon nitride, silicon oxide, or silicon oxynitride. In some example, dielectric wall 112 is low-k dielectric material (materials with a dielectric constant equal to or lower than that of silicon dioxide, such as porous silicon dioxide). According to some embodiments, dielectric wall 112 extends at least through an entire thickness of the gate structures within the gate trenches. In some examples, dielectric wall 112 also extends through an entire thickness of dielectric layer 103 (as illustrated).

According to some embodiments, the conductive portion of via 110 includes a metal liner 114 and a metal fill 116. According to some embodiments, metal liner 114 includes a pure elemental metal directly on dielectric wall 112. For example, metal liner 114 may include pure tungsten, pure molybdenum, pure ruthenium, or a nickel aluminum alloy with no other material layer between itself and dielectric wall 112. Metal liner 114 may be deposited on the inner sidewalls of dielectric wall 112 using an ionized PVD process. According to some such embodiments, the PVD process allows the ionized metal ions to penetrate into dielectric wall 112, thus providing greater adhesion between metal liner 114 and dielectric wall 112. According to some embodiments, metal fill 116 may also include a pure elemental metal (such as the same pure elemental metal as metal liner 114). Metal fill 116 may be deposited on metal liner 114 using a CVD or ALD process. Since both the PVD process and CVD/ALD process for depositing metal liner 114 and metal fill 116 can be performed in situ, no oxidation occurs with the deposited metal, and thus no oxygen atoms are present at the boundary between metal liner 114 and metal fill 116, according to some embodiments. Furthermore, the PVD process for depositing metal liner 114 yields a film that is substantially free of any impurities. For example, metal liner 114 may be free of any carbon, fluorine, and chlorine atoms. In some examples, via 110 has an uppermost width between about 20 nm and about 30 nm. The example depicted has relatively straight via sidewalls, but in other examples, the via may taper inward toward the via bottom. In any such cases, the thickness of liner 114 at the via bottom may be thicker than the thickness of liner 114 on the via sidewalls. For instance, in some such examples, the thickness of liner 114 at the via bottom may be about 2 nm to 4 nm (20 angstroms to 40 angstroms) thicker than the thickness of liner 114 on the via sidewalls

Figure 1B illustrates a plan view of the integrated circuit taken through the 1B plane illustrated in Figure 1A. Nanoribbons 102 from different devices extend between corresponding source or drain regions 118 in the first direction. Source or drain regions 118 may be formed at the ends of the one or more semiconductor regions (such as at the ends of nanoribbons 102) of each device, and thus may be aligned along the second direction from one another within a common source/drain trench. According to some embodiments, source or drain regions 118 are epitaxial regions that are provided on the semiconductor regions in an etch-and-replace process. In other embodiments source or drain regions 118 could be, for example, implantation-doped native portions of the fins or substrate. Any semiconductor materials suitable for source or drain regions can be used (e.g., group IV and group III-V semiconductor materials). Source or drain regions 118 may include multiple layers such as liners and capping layers to improve contact resistance. In any such cases, the composition and doping of source or drain regions 118 may be the same or different, depending on the polarity of the transistors. Any number of source or drain configurations and materials can be used. According to some embodiments, a dielectric fill 120 is provided adjacent to source or drain regions 118 within the source/drain trench. Dielectric fill 120 may be any suitable dielectric material, such as silicon dioxide, and may also extend over a top surface of any of source or drain regions 118. The example of Figure 1B further shows the parallel pattern of different vias 110, all running lengthwise in the first direction. Spacer structures 122 are present between the gate trench and the source/drain trench and may be formed on the sidewalls of the gate structures, according to some embodiments. Accordingly, spacer structures 122 may extend lengthwise along the second direction along with the gate structures. Spacer structures 122 may include any suitable dielectric material, such as silicon nitride, silicon dioxide, or silicon oxynitride.

### Fabrication Methodology

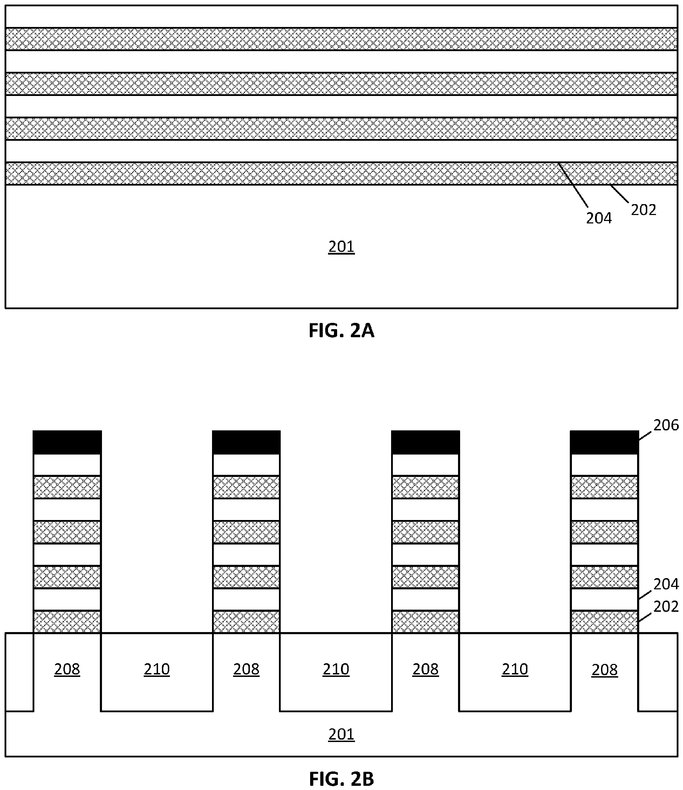

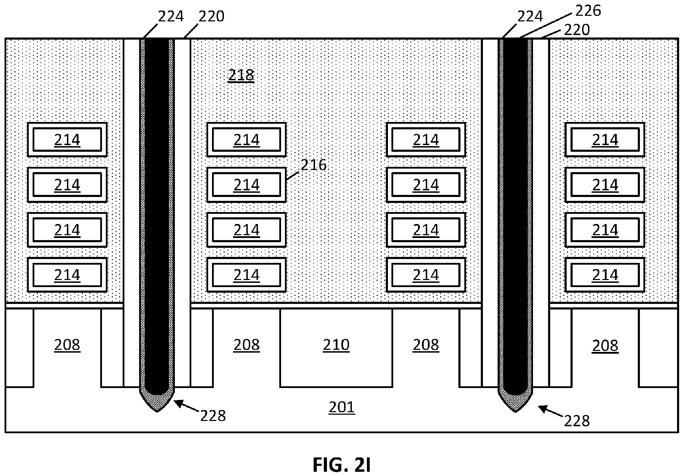

Figures 2A - 2I are cross-sectional views that collectively illustrate an example process for forming an integrated circuit configured with barrier-free deep vias, in accordance with an embodiment of the present disclosure. The figures represent cross-sectional views taken along the YZ plane, as shown in Figure 1A. Each figure shows an example structure that results from the process flow up to that point in time, so the depicted structure evolves as the process flow continues, culminating in the structure shown in Figure 2I, which is similar to the structure shown in Figure 1A. Such a structure may be part of an overall integrated circuit (e.g., such as a processor or memory chip) that includes, for example, digital logic cells and/or memory cells and analog mixed signal circuitry. Thus, the illustrated integrated circuit structure may be part of a larger integrated circuit that includes other integrated circuitry not depicted. Example materials and process parameters are given, but the present disclosure is not intended to be limited to any specific such materials or parameters, as will be appreciated.

Figure 2A illustrates a cross-sectional view of multiple material layers formed over a substrate, according to an embodiment of the present disclosure. Alternating material layers may be deposited over a substrate 201 including sacrificial layers 202 alternating with semiconductor layers 204. The alternating layers are used to form GAA transistor structures. Any number of alternating semiconductor layers 204 and sacrificial layers 202 may be deposited over substrate 201.

According to some embodiments, sacrificial layers 202 have a different material composition than semiconductor layers 204. In some embodiments, sacrificial layers 202 are silicon germanium (SiGe) while semiconductor layers 204 include a semiconductor material suitable for use as a nanoribbon such as silicon (Si), SiGe, germanium, or III-V materials like indium phosphide (InP) or gallium arsenide (GaAs). In examples where SiGe is used in each of sacrificial layers 202 and in semiconductor layers 204, the germanium concentration is different between sacrificial layers 202 and semiconductor layers 204. For example, sacrificial layers 202 may include a higher germanium content compared to semiconductor layers 204. In some examples, semiconductor layers 204 may be doped with either n-type dopants (to produce a p-channel transistor) or p-type dopants (to produce an n-channel transistor).

While dimensions can vary from one example embodiment to the next, the thickness of each sacrificial layer 202 may be between about 5 nm and about 20 nm. In some embodiments, the thickness of each sacrificial layer 202 is substantially the same (e.g., within 1-2 nm). The thickness of each of semiconductor layers 204 may be about the same as the thickness of each sacrificial layer 202 (e.g., about 5-20 nm). Each of sacrificial layers 202 and semiconductor layers 204 may be deposited using any known material deposition technique, such as CVD, plasma-enhanced chemical vapor deposition (PECVD), PVD, or ALD.

Figure 2B depicts the cross-section view of the structure shown in Figure 2A, following the formation of a cap layer 206 and the subsequent formation of fins beneath cap layer 206, according to an embodiment. Cap layer 206 may be any suitable hard mask material such as a carbon hard mask (CHM) or silicon nitride. Cap layer 206 is patterned into rows to form corresponding rows of fins from the alternating layer stack of sacrificial layers 202 and semiconductor layers 204. The rows of fins extend lengthwise in a first direction (e.g., into and out of the page of each cross-section view).

According to some embodiments, an anisotropic etching process through the layer stack continues into at least a portion of substrate 201, where the unetched portions of substrate 201 beneath the fins form subfin regions 208. The etched portions of substrate 201 may be filled with a dielectric fill 210 that acts as shallow trench isolation (STI) between adjacent fins. Dielectric fill 210 may be any suitable dielectric material such as silicon dioxide, and may be recessed to a desired depth as shown (in this example case, down to around the upper surface of subfin regions 208), so as to define the active portion of the fins that will be covered by a gate structure. In some embodiments, dielectric fill 210 is recessed below the top surface of subfin regions 208.

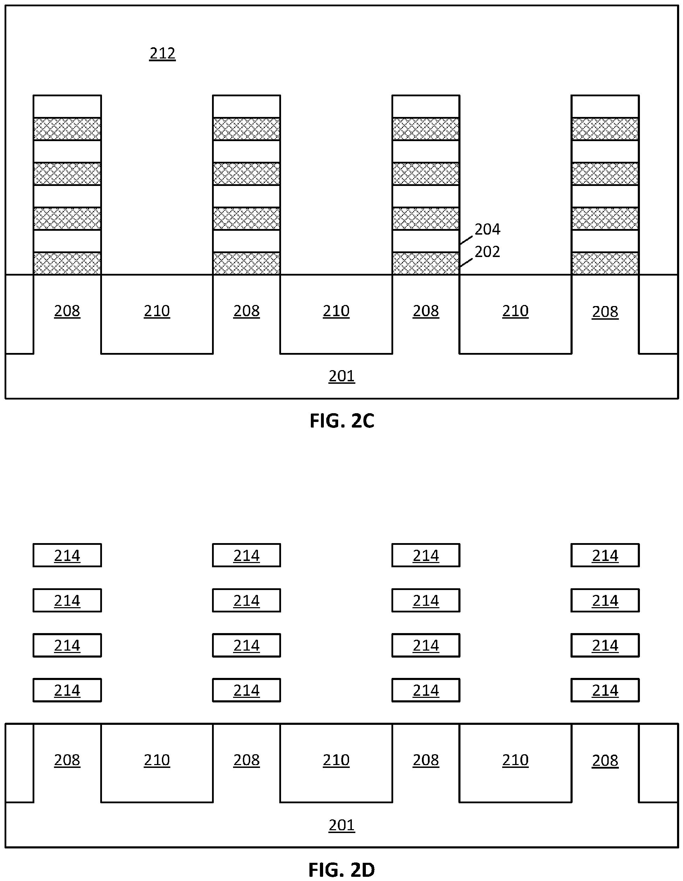

Figure 2C depicts the cross-section view of the structure shown in Figure 2B, following the formation of a sacrificial gate 212 extending across the fins in a second direction different from the first direction, according to some embodiments. Sacrificial gate 212 may extend across the fins in a second direction that is perpendicular to the first direction. According to some embodiments, the sacrificial gate material is formed in parallel strips across the integrated circuit and removed in all areas not protected by a gate masking layer. Sacrificial gate 212 may be any suitable material that can be selectively removed without damaging the semiconductor material of the fins. In some examples, sacrificial gate 212 includes polysilicon.

Sacrificial gate 212 (along with any gate spacers formed on the sidewalls of sacrificial gate 212) protect the underlying portions of the fins while the exposed portions of the fins between the gate spacers are etched away. According to some embodiments, both semiconductor layers 204 and sacrificial layers 202 are etched at substantially the same rate using an anisotropic reactive ion etching (RIE) process to form source/drain trenches. In some embodiments, inner gate spacers can be formed after the source/drain trenches are etched and before any formation of source or drain regions. For instance, a selective etch can be used to laterally recess sacrificial layers 202, and that recess can then be filled with inner gate spacer material (e.g., silicon nitride or silicon oxynitride). Any excess gate spacer material can be removed with directional etching.

According to some embodiments, source or drain regions are formed after the formation of sacrificial gate 212. The source or drain regions are not shown in this cross-section as they would exist at the ends of the semiconductor layers 204 into and out of the page. The source or drain regions may be epitaxially grown from the exposed ends of semiconductor layers 204, such that the material grows together or otherwise merges towards the middle of the trenches between fins, according to some embodiments. Note that epitaxial growth on one semiconductor layer 204 can fully or partially merge with epitaxial growth on one or more other semiconductor layers 204 in the same vertical stack. The degree of any such merging can vary from one embodiment to the next. In the example of a PMOS device, a given source or drain region may be a semiconductor material (e.g., group IV or group III-V semiconductor materials) having a higher dopant concentration of p-type dopants compared to n-type dopants. In the example of an NMOS device, a given source or drain region may be a semiconductor material (e.g., group IV or group III-V semiconductor materials) having a higher dopant concentration of n-type dopants compared to p-type dopants. According to some embodiments, the source or drain regions grown from different semiconductor devices may be aligned along the source/drain trench in the second direction.

Figure 2D depicts the cross-section view of the structure shown in Figure 2C following the formation of nanoribbons 214 from semiconductor layers 204, according to some embodiments. Depending on the dimensions of the structures, nanoribbons 214 may also be considered nanowires or nanosheets. Sacrificial gate 212 may be removed using any wet or dry isotropic process thus exposing the alternating layer stack of the fins within the trenches left behind after the removal of sacrificial gate 212. Once sacrificial gate 212 is removed, sacrificial layers 202 may also be removed using a selective isotropic etching process that removes the material of sacrificial layers 202 but does not remove (or removes very little of) semiconductor layers 204 or any other exposed layers (e.g., inner gate spacers). At this point, the suspended (sometimes called released) semiconductor layers 204 form nanoribbons 214 that extend in the first direction (into and out of the page) between corresponding source or drain regions.

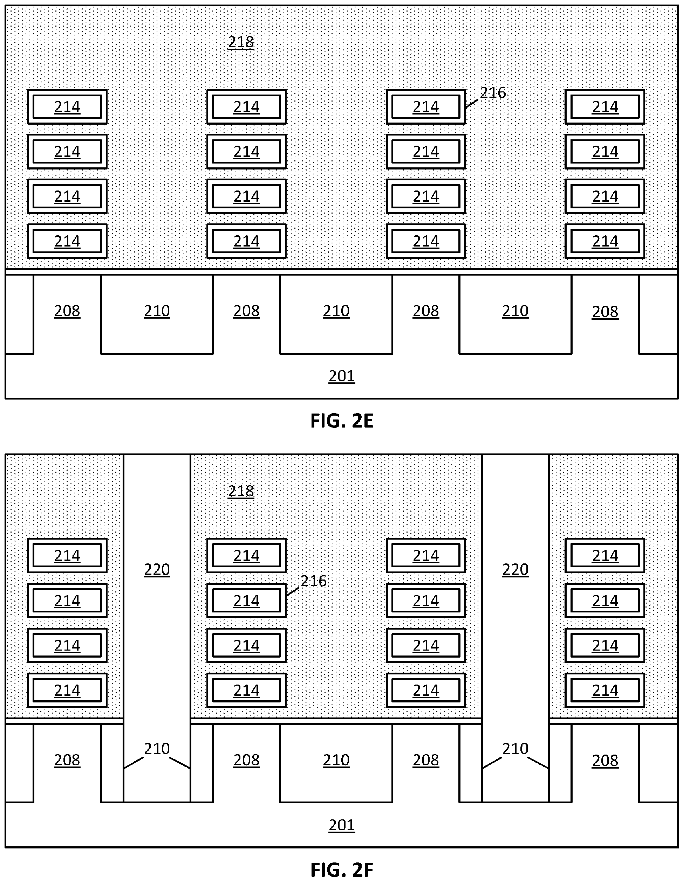

Figure 2E depicts the cross-section view of the structure shown in Figure 2D following the formation of a gate structure around nanoribbons 214 within the gate trench, according to some embodiments. As noted above, the gate structure includes a gate dielectric 216 and a gate electrode 218. Gate dielectric 216 may be conformally deposited around nanoribbons 214 using any suitable deposition process, such as atomic layer deposition (ALD). Gate dielectric 216 may also form along the bottom of the gate trench along the top surfaces of dielectric fill 210 and subfin regions 208. Gate dielectric 216 may include any suitable dielectric (such as silicon dioxide, and/or a high-k dielectric material). Examples of high-k dielectric materials include, for instance, hafnium oxide, hafnium silicon oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, lead scandium tantalum oxide, and lead zinc niobate, to provide some examples. According to some embodiments, gate dielectric 216 is hafnium oxide with a thickness between about 1 nm and about 5 nm. In some embodiments, gate dielectric 216 may include one or more silicates (e.g., titanium silicate, tungsten silicate, niobium silicate, and silicates of other transition metals). Gate dielectric 216 may be a multilayer structure, in some examples. For instance, gate dielectric 216 may include a first layer on nanoribbons 214, and a second layer on the first layer. The first layer can be, for instance, an oxide of the semiconductor layers (e.g., silicon dioxide) and the second layer can be a high-k dielectric material (e.g., hafnium oxide). In some embodiments, an annealing process may be carried out on gate dielectric 216 to improve its quality when a high-k dielectric material is used. In some embodiments, the high-k material can be nitridized to improve its aging resistance.

Gate electrode 218 may be deposited over gate dielectric 216 and can be any conductive structure. In some embodiments, gate electrode 218 includes doped polysilicon, a metal, or a metal alloy. Example suitable metals or metal alloys include aluminum, tungsten, cobalt, molybdenum, ruthenium, titanium, tantalum, copper, and carbides and nitrides thereof. Gate electrode 218 may include, for instance, one or more workfunction layers, resistance-reducing layers, and/or barrier layers. The workfunction layers can include, for example, p-type workfunction materials (e.g., titanium nitride) for PMOS gates, or n-type workfunction materials (e.g., titanium aluminum carbide) for NMOS gates.

Figure 2F depicts the cross-section view of the structure shown in Figure 2E following the formation of dielectric walls 220 extending in the first direction between adjacent devices, according to some embodiments. Dielectric walls 220 extend to a depth at least through an entire thickness of the gate structures to isolate separate gate structures along the second direction. In some embodiments, dielectric walls 220 extend into at least a portion of dielectric fill 210 or through an entire thickness of dielectric fill 210. In some embodiments, dielectric walls 220 extend entirely through dielectric fill 210 and into a portion of substrate 201.

According to some embodiments, dielectric walls 220 may be formed by first forming corresponding gate cut recesses through at least an entire thickness of gate electrode 218 using any suitable metal gate etch process. The gate cut recesses may extend in the first direction through multiple gate trenches and source/drain trenches to isolate adjacent gate structures and source or drain regions. The gate cut recesses may be filled with one or more dielectric materials to form dielectric walls 220. For example, dielectric walls 220 may include only silicon oxide or silicon nitride or silicon carbide, or a low-k version of any of these. According to some embodiments, dielectric walls 220 are not formed between every adjacent pair of devices along the second direction. Dielectric walls 220 may have a top width (along the second direction) between about 40 nm and about 400 nm, although any number of widths can be used, depending on device spacing. In still other embodiments, dielectric walls 220 can include dielectric fill that spans an arbitrary width (e.g., 10s or 100s or 1000s of nanometers wide).

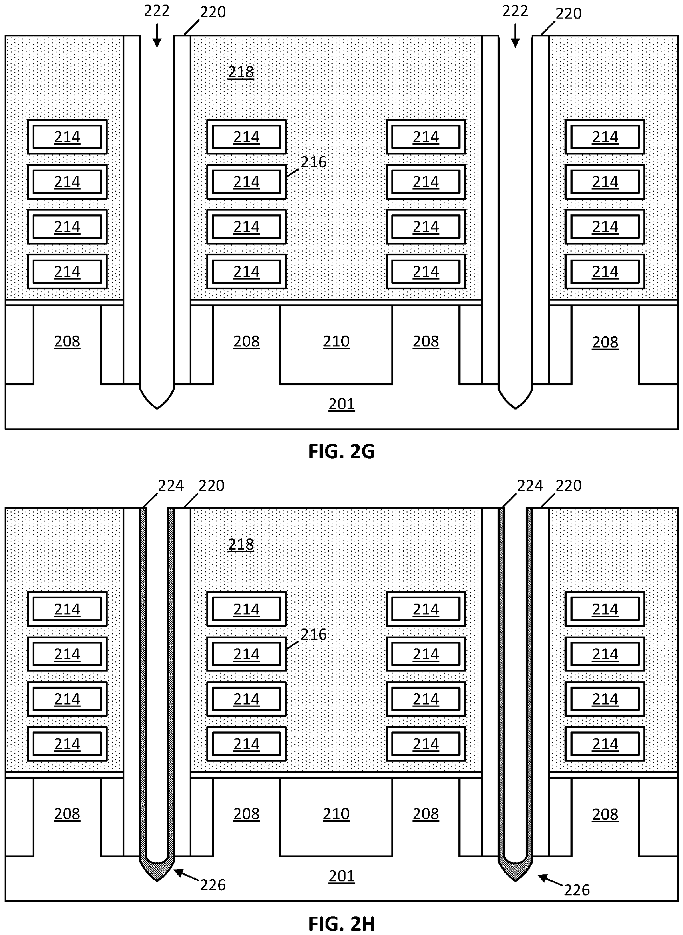

Figure 2G depicts the cross-section view of the structure shown in Figure 2F following the formation of via recesses 222 through dielectric walls 220, according to some embodiments. Recesses 222 may be formed using any suitable RIE process to etch through dielectric walls 220. According to some embodiments, recesses 222 extend at least along an entire thickness of the gate structure. Recesses 222 may continue to extend through an entire thickness of dielectric fill 210. A bottom surface of recesses 222 may have a tapered or otherwise concave shape due to the etching process. Although the sidewalls of recesses 222 are illustrated as being straight, the sidewalls may slope or taper inwards such that a width of recesses 222 along the second direction decreases from the top to the bottom of the recesses. In some examples, recesses 222 may have a top width (along the second direction) between about 20 nm and about 30 nm, which will define an upper width of the via structure being formed. Other examples may have recesses 222 with other widths.

Figure 2H depicts the cross-section view of the structure shown in Figure 2G following the formation of a metal liner 224 within via recesses 222, according to some embodiments. Liner 224 may be a pure elemental metal, such as pure tungsten, pure molybdenum, pure ruthenium, or a nickel aluminum alloy, although other metals can be used (e.g., , titanium, tantalum, cobalt, or any alloys thereof). According to some embodiments, liner 224 is deposited within recesses 222 using an ionized PVD process that yields better adhesion of the metal material to the dielectric surfaces of dielectric walls 220. In some examples, liner 224 may be deposited to a final sidewall thickness within recesses 222 between about 2 nm and about 5 nm. According to some embodiments, liner 224 may be thicker on a bottom surface of recesses 222. In some examples, liner 224 has a thickness between about 5 nm and about 10 nm on the bottom surface (e.g., 60 angstroms), and a thickness between about 2 nm and 5 nm on the sidewalls (e.g., 20 to 40 angstroms).

Figure 2I depicts the cross-section view of the structure shown in Figure 2H following the formation of a metal fill 226 on metal liner 224 within recesses 222, according to some embodiments. Metal fill 226 may fill any remaining volume within recesses 222 to form vias 228. Metal fill 226 may include the same pure elemental metal as metal liner 224. For example, metal fill 226 may include tungsten, molybdenum, ruthenium, titanium, tantalum, cobalt, any alloys thereof, or a nickel aluminum alloy. As noted above, vias 228 may extend at least below a bottom surface of the gate structure and may also extend below a bottom surface of dielectric fill 210.

According to some embodiments, metal fill 226 is formed using a CVD or ALD process, such PECVD. In some examples, the PVD process used to form metal liner 224 and the CVD or ALD process used to form metal fill 226 are performed in situ such that no oxidation occurs to either metal material. Furthermore, the pure elemental metal of metal liner 224 may be substantially free of any impurities, such as any of carbon, fluorine, and chlorine. The top surface of both metal liner 224 and metal fill 226 may be polished to be substantially planar with a top surface of gate electrode 218, or substantially planar with a top surface of a dielectric cap layer on gate electrode 218. The polishing process may be performed using chemical mechanical polishing (CMP).

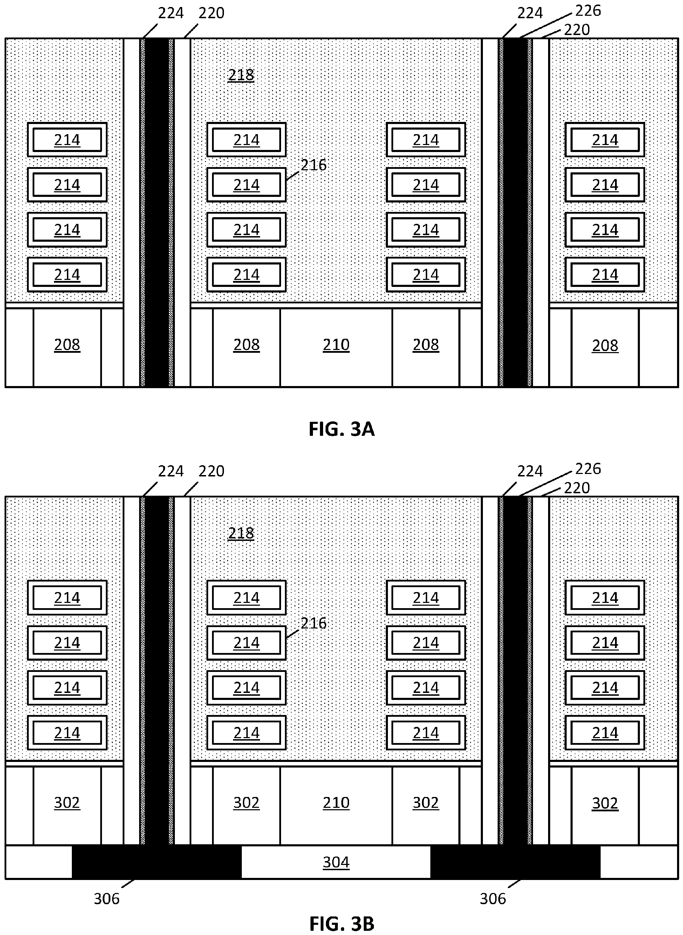

As can be seen in this example, vias 228 may be formed to route various signals to or from backside interconnects, although other interconnect schemes can readily benefit from the via structures described herein. Figure 3A depicts the cross-section view of the structure shown in Figure 2I following the removal of substrate 201, according to some embodiments. Any topside interconnect structures (e.g., back-end-of-the-line structures) may be formed prior to the removal of substrate 201. Substrate 201 may be polished away via CMP or another grinding process to remove the substrate material. According to some embodiments, substrate 201 continues to be thinned away at least until any portion of metal liner 224 or metal fill 226 is exposed from the backside. In some examples, substrate 201 continues to be thinned away at least until a bottom surface of subfin regions 208 and/or dielectric fill 210 is exposed from the backside in the gate trench.

Figure 3B depicts the cross-section view of the structure shown in Figure 3A following the formation of backside interconnect features, according to some embodiments. Subfin regions 208 may first be removed from the backside and replaced with another dielectric fill 302. In some examples, dielectric fill 302 is the same material as dielectric fill 210. In some examples, dielectric fill 210 is also removed to be replaced by dielectric fill 302.

According to some embodiments, an example backside interconnect layer includes a dielectric layer 304 and one or more conductive traces 306. Dielectric layer 304 may include any suitable dielectric material, such as silicon dioxide, silicon nitride, or silicon oxynitride. Conductive traces 306 may include any suitable conductive materials, such as tungsten, ruthenium, molybdenum, or cobalt. In some examples, conductive traces 306 include the same conductive material as metal fill 226 and/or metal liner 224. In some examples, conductive traces 306 contact a lower surface of metal fill 226 and/or metal liner 224 to route power or signal to/from conductive traces 306. Dielectric walls 220 do not extend through any portion of the backside dielectric layer 304, according to some embodiments.

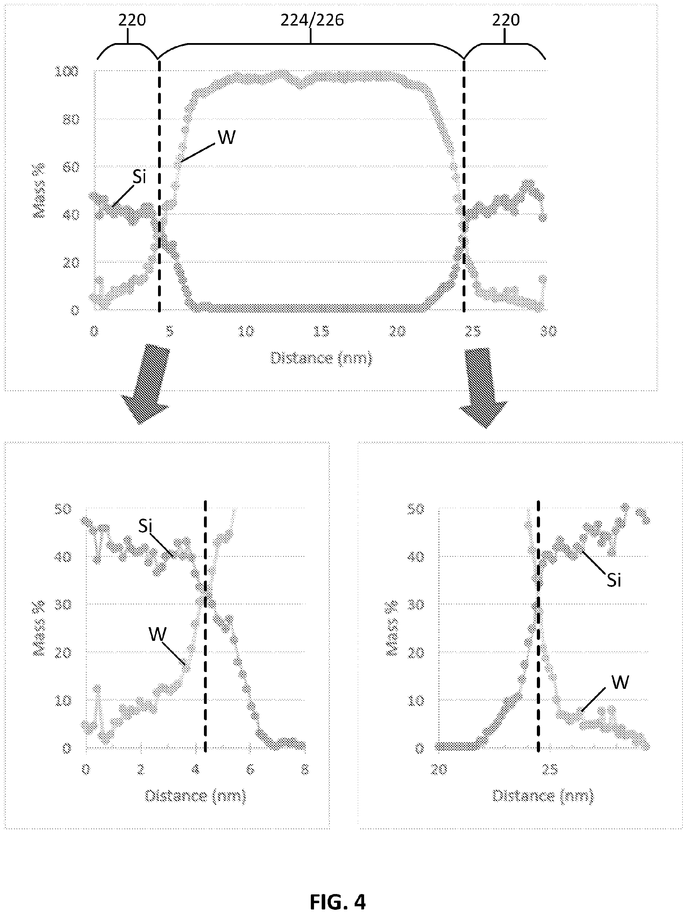

Figure 4 shows an EDX analysis taken across the metal via (including both metal liner 224 and metal fill 226) and across portions of dielectric walls 220. In this example, tungsten (W) is the pure metal used in both metal liner 224 and metal fill 226, while silicon (Si) is present within dielectric walls 220 (e.g., silicon dioxide or silicon nitride). The dotted lines identify the approximated location of the sidewalls of dielectric walls 220.

According to some embodiments, the element from metal liner 224 penetrates into the sidewalls of dielectric walls 220 during the deposition process. For example, a PVD process causes some of the metal atoms to penetrate into the sidewall, thus improving adhesion to the sidewall surface. As can be observed in the EDX data, tungsten has penetrated about 3.0 nm, about 3.5 nm, about 4.0 nm, about 4.5 nm, or about 5.0 nm laterally into sidewalls of dielectric walls 220. Additionally, the physical bombardment causes some intermixing of the silicon atoms with metal liner 224. Thus, according to some embodiments, the silicon atoms intermix about 2 nm, about 2.5 nm, about 3 nm, or about 3.5 nm into metal liner 224. Beyond metal liner 224, metal fill 226 is observed to have 100%, or nearly 100%, pure tungsten.

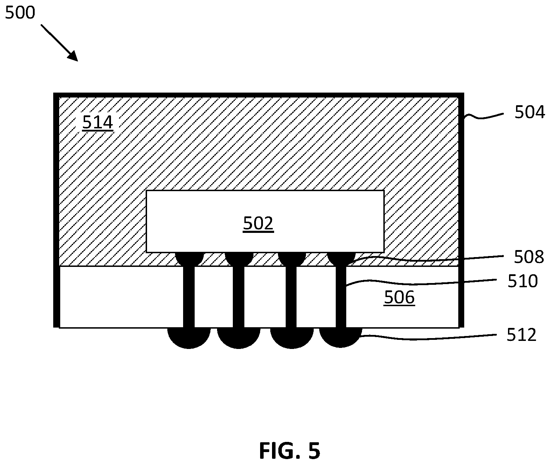

Figure 5 illustrates an example embodiment of a chip package 500, in accordance with an embodiment of the present disclosure. As can be seen, chip package 500 includes one or more dies 502. One or more dies 502 may include at least one integrated circuit having semiconductor devices, such as any of the semiconductor devices disclosed herein. One or more dies 502 may include any other circuitry used to interface with other devices formed on the dies, or other devices connected to chip package 500, in some example configurations.

As can be further seen, chip package 500 includes a housing 504 that is bonded to a package substrate 506. The housing 504 may be any standard or proprietary housing, and may provide, for example, electromagnetic shielding and environmental protection for the components of chip package 500. The one or more dies 502 may be conductively coupled to a package substrate 506 using connections 508, which may be implemented with any number of standard or proprietary connection mechanisms, such as solder bumps, ball grid array (BGA), pins, or wire bonds, to name a few examples. Package substrate 506 may be any standard or proprietary package substrate, but in some cases includes a dielectric material having conductive pathways (e.g., including conductive vias and lines) extending through the dielectric material between the faces of package substrate 506, or between different locations on each face. In some embodiments, package substrate 506 may have a thickness less than 1 millimeter (e.g., between 0.1 millimeters and 0.5 millimeters), although any number of package geometries can be used. Additional conductive contacts 512 may be disposed at an opposite face of package substrate 506 for conductively contacting, for instance, a printed circuit board (PCB). One or more vias 510 extend through a thickness of package substrate 506 to provide conductive pathways between one or more of connections 508 to one or more of contacts 512. Vias 510 are illustrated as single straight columns through package substrate 506 for ease of illustration, although other configurations can be used (e.g., damascene, dual damascene, through-silicon via, or an interconnect structure that meanders through the thickness of substrate 506 to contact one or more intermediate locations therein). In still other embodiments, vias 510 are fabricated by multiple smaller stacked vias, or are staggered at different locations across package substrate 506. In the illustrated embodiment, contacts 512 are solder balls (e.g., for bump-based connections or a ball grid array arrangement), but any suitable package bonding mechanism may be used (e.g., pins in a pin grid array arrangement or lands in a land grid array arrangement). In some embodiments, a solder resist is disposed between contacts 512, to inhibit shorting.

In some embodiments, a mold material 514 may be disposed around the one or more dies 502 included within housing 504 (e.g., between dies 502 and package substrate 506 as an underfill material, as well as between dies 502 and housing 504 as an overfill material). Although the dimensions and qualities of the mold material 514 can vary from one embodiment to the next, in some embodiments, a thickness of mold material 514 is less than 1 millimeter. Example materials that may be used for mold material 514 include epoxy mold materials, as suitable. In some cases, the mold material 514 is thermally conductive, in addition to being electrically insulating.

### Methodology

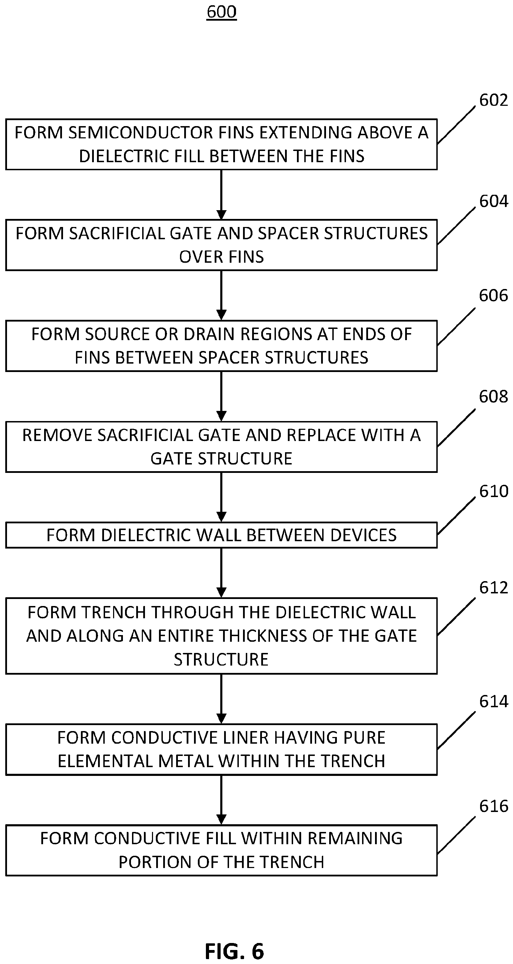

Figure 6 is a flow chart of a method 600 for forming at least a portion of an integrated circuit, according to an embodiment. Various operations of method 600 may be illustrated in Figures 2A-2I. However, the correlation of the various operations of method 600 to the specific components illustrated in the aforementioned figures is not intended to imply any structural and/or use limitations. Rather, the aforementioned figures provide one example embodiment of method 600. Other operations may be performed before, during, or after any of the operations of method 600. For example, method 600 does not explicitly describe many processes that are performed to form common transistor structures. In other examples, the operations of method 600 may be performed in a different order than the illustrated order.

Method 600 begins with operation 602 where a plurality of semiconductor fins are formed, according to some embodiments. The semiconductor material in the fins may be formed from a substrate such that the fins are an integral part of the substrate (e.g., etched from a bulk silicon substrate). Alternatively, the fins can be formed of material deposited onto an underlying substrate. In one such example case, a blanket layer of silicon germanium (SiGe) can be deposited onto a silicon substrate, and then patterned and etched to form a plurality of SiGe fins extending from that substrate. In another such example, non-native fins can be formed in a so-called aspect ratio trapping based process, where native fins are etched away so as to leave fin-shaped trenches which can then be filled with an alternative semiconductor material (e.g., group IV or III-V material). In still other embodiments, the fins include alternating layers of material (e.g., alternating layers of silicon and SiGe) that facilitates forming of nanowires and nanoribbons during a gate forming process where one type of the alternating layers are selectively etched away so as to liberate the other type of alternating layers within the channel region, so that a gate-all-around (GAA) process can then be carried out. Again, the alternating layers can be blanket deposited and then etched into fins, or deposited into fin-shaped trenches.

According to some embodiments, a dielectric fill is formed adjacent to subfin portions of each of the fins. The dielectric fill may include silicon dioxide. According to some embodiments, the dielectric fill acts as an STI region between adjacent fins. According to some embodiments, each semiconductor device includes a subfin portion beneath a fin of alternating semiconductor layers and adjacent to the dielectric fill. The subfin may include the same material as a bulk region of the underlying semiconductor substrate.

Method 600 continues with operation 604 where a sacrificial gate and sidewall spacer structures are formed over the fins. The sacrificial gate may include any material that can be safely removed later in the process without etching or otherwise damaging the spacer structures and/or the fins. The sacrificial gate may include polysilicon while the spacer structures may include silicon nitride. The spacer structures are formed on sidewalls of the sacrificial gates and etched back to remove the spacer structure material from any horizontal surfaces. According to some embodiments, the fins extend lengthwise in a first direction while the sacrificial gate and spacer structures extend lengthwise in a second direction over each of the fins, the second direction being substantially perpendicular to the first direction.

Method 600 continues with operation 606 where source or drain regions are formed at the ends of semiconductor channel layers in each of the fins. Exposed portions of the fins not covered by the sacrificial gate and sidewall spacer structures may first be removed using, for example, an RIE process. Removing the fin portions exposes ends of one or more semiconductor channel layers extending in the first direction through the sacrificial gate and sidewall spacer structures. The source or drain regions may be epitaxially grown from the exposed ends of the semiconductor layers. In the example of a PMOS device, the corresponding source or drain region may be a semiconductor material (e.g., group IV or group III-V semiconductor materials) having a higher dopant concentration of p-type dopants compared to n-type dopants. In the example of an NMOS device, the corresponding source or drain region may be a semiconductor material (e.g., group IV or group III-V semiconductor materials) having a higher dopant concentration of n-type dopants compared to p-type dopants.

Method 600 continues with operation 608 where sacrificial materials are removed and the gate structure is formed. The sacrificial gate may be removed using an isotropic etching process that selectively removes all of the material from the sacrificial gate, thus exposing the first and second fins between the spacer structures. In the example case where GAA transistors are used, any sacrificial layers within the exposed fins between the spacer structures are also removed to leave behind nanoribbons, nanosheets, or nanowires of semiconductor material.

The gate structure may include both a gate dielectric and a gate electrode. The gate dielectric is first formed over the exposed semiconductor regions between the spacer structures followed by forming the gate electrode within the remainder of the trench between the spacer structures, according to some embodiments. The gate dielectric may include any number of dielectric layers deposited using a CVD process, such as ALD. The gate electrode can include any conductive material, such as a metal, metal alloy, or polysilicon. The gate electrode may be deposited using electroplating, electroless plating, CVD, ALD, PECVD, or PVD, to name a few examples.

Method 600 continues with operation 610 where dielectric walls are formed between devices or at least through the gate structure. Deep recesses are first formed through at least a full thickness of the gate structure and extending in the first direction into the source/drain trenches and through other gate trenches. The deep recesses may be formed using a metal gate etch process that iteratively etches through portions of the gate electrode while simultaneously protecting the sidewalls of the recess from lateral etching. According to some embodiments, the deep recesses also cut through at least a portion of the dielectric fill adjacent to the subfin portions.

The deep recesses are filled with one or more dielectric materials to form the dielectric walls. For example, the dielectric material may include silicon dioxide, silicon nitride, or silicon oxynitride. In some examples, the deep recesses are filled with the same dielectric material as the dielectric fill between the semiconductor fins.

Method 600 continues with operation 612 where a trench is formed through the dielectric wall and along at least an entire thickness of the gate structure. The trench may be formed through a central portion of the dielectric wall and extend lengthwise in the first direction along with the dielectric wall. According to some embodiments, the trench extends below a bottom surface of the dielectric fill between the semiconductor fins. The trench may be formed using a deep reactive ion etching (DRIE) process.

Method 600 continues with operation 614 where a conductive liner having a pure elemental metal is formed within the trench. According to some embodiments, the conductive liner includes pure tungsten, pure molybdenum, pure ruthenium, or a nickel aluminum alloy. In other examples, the conductive liner includes any suitable metal having a high atomic weight (e.g., greater than 90). According to some embodiments, the conductive liner is deposited using an ionized PVD process, such as sputtering, that yields better adhesion of the metal material to the dielectric surfaces of the dielectric walls. In some examples, the conductive liner may be deposited to a final sidewall thickness within the trench between about 2 nm and about 5 nm. According to some embodiments, the conductive liner may be thicker on a bottom surface of the trench, such as between about 5 nm and about 10 nm on the bottom surface.

Method 600 continues with operation 616 where a conductive fill is formed within a remaining portion of the trench and on the conductive liner. The conductive fill may include the same pure elemental metal as the conductive liner, or may include any other suitable conductive material such as, titanium, tantalum, cobalt, or any alloys thereof.

According to some embodiments, the conductive fill is formed using a CVD or ALD process, such PECVD. In some examples, the PVD process used to form the conductive liner and the CVD process used to form the conductive fill are performed in situ such that no oxidation occurs to either metal material. Furthermore, the pure elemental metal of the conductive liner may be substantially free of any impurities, such as any of carbon, fluorine, and chlorine.

### Example System

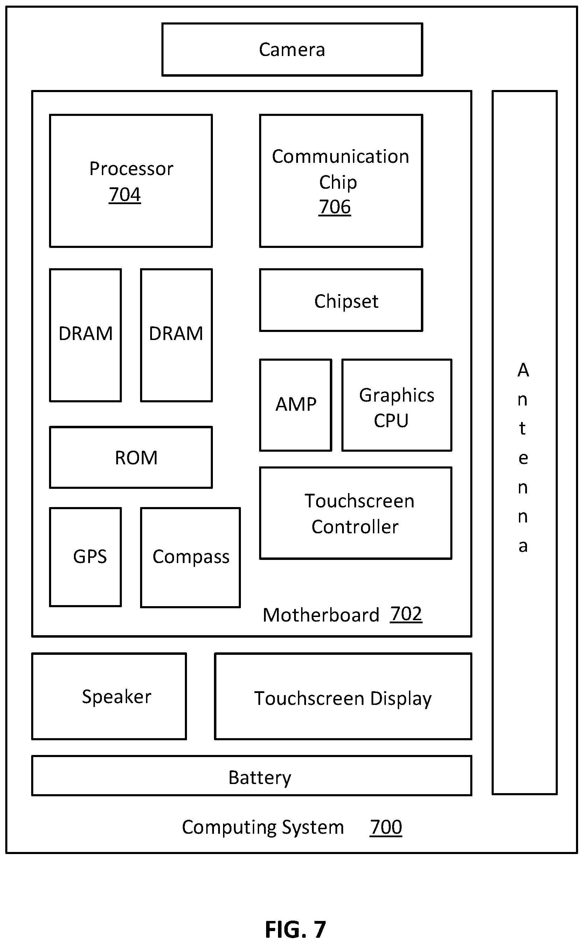

FIG. 7 is an example computing system implemented with one or more of the integrated circuit structures as disclosed herein, in accordance with some embodiments of the present disclosure. As can be seen, the computing system 700 houses a motherboard 702. The motherboard 702 may include a number of components, including, but not limited to, a processor 704 and at least one communication chip 706, each of which can be physically and electrically coupled to the motherboard 702, or otherwise integrated therein. As will be appreciated, the motherboard 702 may be, for example, any printed circuit board (PCB), whether a main board, a daughterboard mounted on a main board, or the only board of system 700, etc.

Depending on its applications, computing system 700 may include one or more other components that may or may not be physically and electrically coupled to the motherboard 702. These other components may include, but are not limited to, volatile memory (e.g., DRAM), non-volatile memory (e.g., ROM), a graphics processor, a digital signal processor, a crypto processor, a chipset, an antenna, a display, a touchscreen display, a touchscreen controller, a battery, an audio codec, a video codec, a power amplifier, a global positioning system (GPS) device, a compass, an accelerometer, a gyroscope, a speaker, a camera, and a mass storage device (such as hard disk drive, compact disk (CD), digital versatile disk (DVD), and so forth). Any of the components included in computing system 700 may include one or more integrated circuit structures or devices configured in accordance with an example embodiment (e.g., a module including an integrated circuit device on a substrate, the substrate having one or more semiconductor devices with low-resistance vias, as variously provided herein). In some embodiments, multiple functions can be integrated into one or more chips (e.g., for instance, note that the communication chip 706 can be part of or otherwise integrated into the processor 704).

The communication chip 706 enables wireless communications for the transfer of data to and from the computing system 700. The term "wireless" and its derivatives may be used to describe circuits, devices, systems, methods, techniques, communications channels, etc., that may communicate data through the use of modulated electromagnetic radiation through a non-solid medium. The term does not imply that the associated devices do not contain any wires, although in some embodiments they might not. The communication chip 706 may implement any of a number of wireless standards or protocols, including, but not limited to, Wi-Fi (IEEE 802.11 family), WiMAX (IEEE 802.16 family), IEEE 802.20, long term evolution (LTE), Ev-DO, HSPA+, HSDPA+, HSUPA+, EDGE, GSM, GPRS, CDMA, TDMA, DECT, Bluetooth, derivatives thereof, as well as any other wireless protocols that are designated as 3G, 4G, 5G, and beyond. The computing system 700 may include a plurality of communication chips 706. For instance, a first communication chip 706 may be dedicated to shorter range wireless communications such as Wi-Fi and Bluetooth and a second communication chip 706 may be dedicated to longer range wireless communications such as GPS, EDGE, GPRS, CDMA, WiMAX, LTE, Ev-DO, and others.

The processor 704 of the computing system 700 includes an integrated circuit die packaged within the processor 704. In some embodiments, the integrated circuit die of the processor includes onboard circuitry that is implemented with one or more semiconductor devices as variously described herein. The term "processor" may refer to any device or portion of a device that processes, for instance, electronic data from registers and/or memory to transform that electronic data into other electronic data that may be stored in registers and/or memory.

The communication chip 706 also may include an integrated circuit die packaged within the communication chip 706. In accordance with some such example embodiments, the integrated circuit die of the communication chip includes one or more semiconductor devices as variously described herein. As will be appreciated in light of this disclosure, note that multi-standard wireless capability may be integrated directly into the processor 704 (e.g., where functionality of any chips 706 is integrated into processor 704, rather than having separate communication chips). Further note that processor 704 may be a chip set having such wireless capability. In short, any number of processor 704 and/or communication chips 706 can be used. Likewise, any one chip or chip set can have multiple functions integrated therein.

In various implementations, the computing system 700 may be a laptop, a netbook, a notebook, a smartphone, a tablet, a personal digital assistant (PDA), an ultra-mobile PC, a mobile phone, a desktop computer, a server, a printer, a scanner, a monitor, a set-top box, an entertainment control unit, a digital camera, a portable music player, a digital video recorder, or any other electronic device that processes data or employs one or more integrated circuit structures or devices formed using the disclosed techniques, as variously described herein.

It will be appreciated that in some embodiments, the various components of the computing system 700 may be combined or integrated in a system-on-a-chip (SoC) architecture. In some embodiments, the components may be hardware components, firmware components, software components or any suitable combination of hardware, firmware or software.

### Further Example Embodiments

The following examples pertain to further embodiments, from which numerous permutations and configurations will be apparent.

Example 1 is an integrated circuit that includes a semiconductor device having a semiconductor region extending in a first direction from a first source or drain region, and a gate electrode extending in a second direction over the semiconductor region, and a conductive via extending in a third direction through an entire thickness of the gate electrode and adjacent to the semiconductor device in the second direction. The conductive via comprises a conductive liner and a conductive fill on the conductive liner. The conductive liner includes a pure elemental metal.

Example 2 includes the integrated circuit of Example 1, further comprising a dielectric wall extending in the third direction through the entire thickness of the gate electrode, wherein the conductive via extends through an entire thickness of the dielectric wall in the third direction.

Example 3 includes the integrated circuit of Example 2, wherein the dielectric wall comprises a low-k dielectric material.

Example 4 includes the integrated circuit of Example 2 or 3, wherein the conductive liner consists essentially of the pure elemental metal and is directly on the dielectric wall.

Example 5 includes the integrated circuit of any one of Examples 1-4, wherein the pure elemental metal is tungsten.

Example 6 includes the integrated circuit of any one of Examples 1-4, wherein the pure elemental metal is molybdenum.

Example 7 includes the integrated circuit of any one of Examples 1-6, wherein the conductive fill comprises the pure elemental metal.

Example 8 includes the integrated circuit of any one of Examples 1-7, wherein the pure elemental metal is a first pure elemental metal, and wherein the conductive fill comprises a second pure elemental metal different from the first pure elemental metal.

Example 9 includes the integrated circuit of Example 8, wherein the first pure elemental metal is molybdenum, and the second pure elemental metal is tungsten.

Example 10 includes the integrated circuit of any one of Examples 1-9, wherein the conductive liner has a first thickness on sidewalls of the via, and a second thickness on a bottom of the via, the second thickness being at least 2 nm thicker than the first thickness.

Example 11 includes the integrated circuit of any one of Examples 1-10, wherein no oxygen atoms exist at an interface between the conductive liner and the conductive fill.

Example 12 includes the integrated circuit of any one of Examples 1-11, wherein no carbon, fluorine, or chlorine atoms exist within the conductive liner.

Example 13 includes the integrated circuit of any one of Examples 1-12, wherein the semiconductor region comprises a plurality of semiconductor nanoribbons.

Example 14 includes the integrated circuit of Example 13, wherein the plurality of semiconductor nanoribbons comprise germanium, silicon, or a combination thereof.

Example 15 includes the integrated circuit of any one of Examples 1-14, wherein the second direction is substantially perpendicular to the first direction, and the third direction is substantially perpendicular to the first and second directions.

Example 16 includes the integrated circuit of any one of Examples 1-15, wherein the conductive via extends in the first direction adjacent to the source or drain region.

Example 17 is a printed circuit board comprising the integrated circuit of any one of Examples 1-16.

Example 18 is an electronic device that includes a chip package having one or more dies. At least one of the one or more dies includes a semiconductor region extending in a first direction from a first source or drain region to a second source or drain region, a gate structure extending in a second direction over the semiconductor region, and a conductive via extending in a third direction through an entire thickness of the gate structure and adjacent to the semiconductor region in the second direction. The conductive via comprises a conductive liner and a conductive fill on the conductive liner. The conductive liner comprises a pure elemental metal.

Example 19 includes the electronic device of Example 18, wherein the at least one of the one or more dies further comprises a dielectric wall extending in the third direction through the entire thickness of the gate structure, wherein the conductive via extends through an entire thickness of the dielectric wall in the third direction.

Example 20 includes the electronic device of Example 19, wherein the dielectric wall comprises a low-k dielectric material.

Example 21 includes the electronic device of Example 19 or 20, wherein the conductive liner is directly on the dielectric wall.

Example 22 includes the electronic device of any one of Examples 18-21, wherein the pure elemental metal is tungsten.

Example 23 includes the electronic device of any one of Examples 18-21, wherein the pure elemental metal is molybdenum.

Example 24 includes the electronic device of any one of Examples 18-23, wherein the conductive fill comprises the pure elemental metal.

Example 25 includes the electronic device of any one of Examples 18-24, wherein no oxygen atoms exist at an interface between the conductive liner and the conductive fill.

Example 26 includes the electronic device of any one of Examples 18-25, wherein no carbon, fluorine, or chlorine atoms exist within the conductive liner.

Example 27 includes the electronic device of any one of Examples 18-26, wherein the semiconductor region comprises a plurality of semiconductor nanoribbons.

Example 28 includes the electronic device of Example 27, wherein the plurality of semiconductor nanoribbons comprise germanium, silicon, or a combination thereof.

Example 29 includes the electronic device of any one of Examples 18-28, wherein the second direction is substantially perpendicular to the first direction, and the third direction is substantially perpendicular to the first and second directions.

Example 30 includes the electronic device of any one of Examples 18-29, wherein the conductive via extends in the first direction adjacent to the first source or drain region and the second source or drain region.

Example 31 includes the electronic device of any one of Examples 18-30, further comprising a printed circuit board, wherein the chip package is coupled to the printed circuit board.

Example 32 is a method of forming an integrated circuit. The method includes forming a fin comprising semiconductor material, the fin extending above a substrate and extending in a first direction; forming a dielectric layer adjacent to a subfin portion of the fin; forming source or drain regions at opposite ends of the fin; forming a gate structure on the dielectric layer and over the semiconductor material and extending in a second direction; forming a dielectric wall through an entire thickness of the gate structure, the dielectric wall extending in the first direction adjacent to the fin; forming a trench through the dielectric wall, such that the trench extends along at least an entire thickness of the gate structure; forming a conductive liner comprising a pure elemental metal within the trench; and forming a conductive fill within a remaining portion of the trench on the conductive liner.

Example 33 includes the method of Example 32, wherein forming the conductive liner comprises forming the conductive liner using an ionized physical vapor deposition (PVD) process.

Example 34 includes the method of Example 32 or 33, wherein forming the conductive fill comprises forming the conductive fill using a chemical vapor deposition (CVD) or an atomic layer deposition (ALD) process.

Example 35 includes the method of any one of Examples 32-34, wherein forming the conductive fill comprises forming the conductive fill comprising the pure elemental metal.

Example 36 includes the method of any one of Examples 32-35, wherein the pure elemental metal is tungsten or molybdenum.

Example 37 includes the method of any one of Examples 32-36, further comprising forming a conductive layer beneath the dielectric layer such that the conductive layer contacts the conductive fill and/or the conductive liner.

Example 38 is an integrated circuit that includes a first semiconductor device having a first semiconductor region extending in a first direction from a first source or drain region to a second source or drain region and a first gate structure extending in a second direction over the first semiconductor region, and a second semiconductor device having a second semiconductor region extending in the first direction from a third source or drain region to a fourth source or drain region and a second gate structure extending in the second direction over the second semiconductor region. The third source or drain region is aligned with the first source or drain region along the second direction, and the fourth source or drain region is aligned with the second source or drain region along the second direction. The integrated circuit further includes a dielectric structure extending in the first direction between and contacting the first gate structure and the second gate structure. The dielectric structure also extends in a third direction through an entire thickness of each of the first gate structure and the second gate structure. The integrated circuit further includes a conductive via extending in a third direction through an entire thickness of the dielectric structure. The conductive via comprises a conductive liner and a conductive fill on the conductive liner. The conductive liner consists essentially of a pure elemental metal directly on the dielectric structure.

Example 39 includes the integrated circuit of Example 38, wherein the dielectric structure comprises a low-k dielectric material.

Example 40 includes the integrated circuit of Example 38 or 39, wherein the pure elemental metal is tungsten.

Example 41 includes the integrated circuit of Example 38 or 39, wherein the pure elemental metal is molybdenum.

Example 42 includes the integrated circuit of any one of Examples 38-41, wherein the conductive fill comprises the pure elemental metal.

Example 43 includes the integrated circuit of any one of Examples 38-42, wherein no oxygen atoms exist at an interface between the conductive liner and the conductive fill.

Example 44 includes the integrated circuit of any one of Examples 38-43, wherein no carbon, fluorine, or chlorine atoms exist within the conductive liner.

Example 45 includes the integrated circuit of any one of Examples 38-44, wherein the second direction is substantially perpendicular to the first direction, and the third direction is substantially perpendicular to the first and second directions.

Example 46 includes the integrated circuit of any one of Examples 38-45, wherein the conductive via extends in the first direction between the first source or drain region and the third source or drain region and in the first direction between the second source or drain region and the fourth source or drain region.

Example 47 includes the integrated circuit of any one of Examples 38-46, wherein the pure elemental metal is a first pure elemental metal, and wherein the conductive fill comprises a second pure elemental metal different from the first elemental metal.

Example 48 includes the integrated circuit of Example 47, wherein the first pure elemental metal is molybdenum, and the second pure elemental metal is tungsten.

Example 49 includes the integrated circuit of any one of Examples 38-48, wherein the conductive liner has a first thickness on sidewalls of the dielectric structure, and a second thickness on a bottom of the via, the second thickness being at least 2 nm thicker than the first thickness.

Example 50 is a printed circuit board comprising the integrated circuit of any one of Examples 38-49.

Example 51 includes the integrated circuit of any one of Examples 2-4, wherein tungsten atoms of the conductive liner penetrate about 4.5 nm into the dielectric wall.

Example 52 includes the integrated circuit of any one of Examples 2-4 or 51, wherein silicon atoms of the dielectric wall penetrate about 3.0 nm into the conductive liner.

The foregoing description of the embodiments of the disclosure has been presented for the purposes of illustration and description. It is not intended to be exhaustive or to limit the disclosure to the precise forms disclosed. Many modifications and variations are possible in light of this disclosure. It is intended that the scope of the disclosure be limited not by this detailed description, but rather by the claims appended hereto.

## Claims

1. An integrated circuit comprising:
a semiconductor device having a semiconductor region extending in a first direction from a source or drain region, and a gate electrode extending in a second direction over the semiconductor region; and
a conductive via extending in a third direction through an entire thickness of the gate electrode and adjacent to the semiconductor device in the second direction, wherein the conductive via comprises a conductive liner and a conductive fill on the conductive liner, and wherein the conductive liner comprises a pure elemental metal.

2. The integrated circuit of claim 1, further comprising a dielectric wall extending in the third direction through the entire thickness of the gate electrode, wherein the conductive via extends through an entire thickness of the dielectric wall in the third direction.

3. The integrated circuit of claim 2, wherein the dielectric wall comprises a low-k dielectric material.

4. The integrated circuit of claim 2 or 3, wherein the conductive liner consists essentially of the pure elemental metal and is directly on the dielectric wall.

5. The integrated circuit of any one of claims 1 through 4, wherein the pure elemental metal is tungsten or molybdenum.

6. The integrated circuit of any one of claims 1 through 5, wherein the conductive fill comprises the pure elemental metal.

7. The integrated circuit of any one of claims 1 through 6, wherein the pure elemental metal is a first pure elemental metal, and wherein the conductive fill comprises a second pure elemental metal different from the first pure elemental metal.

8. The integrated circuit of claim 7, wherein the first pure elemental metal is molybdenum, and the second pure elemental metal is tungsten.

9. The integrated circuit of any one of claims 1 through 8, wherein the conductive liner has a first thickness on sidewalls of the via, and a second thickness on a bottom of the via, the second thickness being at least 2 nm thicker than the first thickness.

10. The integrated circuit of any one of claims 1 through 9, wherein no oxygen atoms exist at an interface between the conductive liner and the conductive fill.

11. The integrated circuit of any one of claims 1 through 10, wherein no carbon, fluorine, or chlorine atoms exist within the conductive liner.

12. The integrated circuit of any one of claims 1 through 11, wherein the semiconductor region comprises a plurality of semiconductor nanoribbons.

13. The integrated circuit of any one of claims 1 through 12, wherein the second direction is substantially perpendicular to the first direction, and the third direction is substantially perpendicular to the first and second directions.

14. The integrated circuit of any one of claims 1 through 13, wherein the conductive via extends in the first direction adjacent to the source or drain region.

15. A printed circuit board comprising the integrated circuit of any one of claims 1 through 14.
